# EUROPEAN PATENT APPLICATION

(11) **EP 1 785 970 A1**
(43) Date of publication of application: **16.05.2007**
(21) Application number: 05780460.1
(22) Date of filing: 22.08.2005
(51) Int. Cl.: G09F 9/00, H05K 5/02

(54) **DISPLAY DEVICE**

(30) Priority: 30.08.2004 JP 2004250114
(71) Applicant: KABUSHIKI KAISHA TOSHIBA, Tokyo 105-8001 (JP)
(72) Inventor: KOIWA, Kaoru, Intellectual Property Division, Minato-ku, Tokyo 105-8001 (JP)
(74) Representative: HOFFMANN EITLE
(86) International application number: PCT/JP2005/015216
(87) International publication number: WO 2006/025227

(57) **Abstract**

A reinforcing plate (2) holding a display panel
(1) is coupled with two plates (21, 22), constituting a hollow structure. Beads (2x) and beads (2y) are provided on one surface (2A) of the reinforcing plate
(2). Further, the peripheral edges of the reinforcing plate (2) cover the peripheral edges of the display panel (1).

## Description

### Technical Field

The present invention relates to a display device having a flat display panel. More particularly, the invention relates to a display device that has reinforcing members for supporting the flat display panel.

### Background Art

In recent years, flat-type displays of various types have been attracting attention, as next-generation, thin and light displays to take place of cathode-ray tubes (hereinafter referred to as CRTs). Surface-conduction electron-emitter displays (hereinafter referred to as SEDs) have been developed, which are one type of the field-emission display (hereinafter referred to as FED) used as a flat-type display.

The SEDs have a display panel. The display panel is a vacuum envelope. The vacuum envelope comprises a front substrate and a rear substrate. The substrates are made of glass and face each other, with a preset gap between them. They are bonded to each other, at their peripheral edges, with a rectangular sidewall interposed between them, providing the vacuum envelope. On the inner surface of the front substrate, phosphor layers of three colors are formed. On the inner surface of the rear substrate, a number of electron emission elements are arranged and used as sources of electrons. The electrons emitted from these elements excite the phosphor layers, causing them to emit light. Each electron emission element, which corresponds to one pixel, comprises an electron-emitting member and a pair of electrodes. The electrodes apply a voltage to the electron-emitting member.

The SED, which is a thin display including a display panel made of glass, is not so resistant to impacts. It may be cracked or broken upon receiving an impact. Even if packaged in a cardboard box or a styrene foam box, the SED may be damaged when it receives an impact while being transported.

Jpn. Pat. Appln. KOKAI Publication No. 2004-126456, for example, discloses a blanket for holding a display body and a stand device for holding the same by using the blanket, in order to reinforce the display body. The blanket and the stand device can be made produced at low cost and with good processibility. The blanket is secured to the stand device with reinforcing shafts such as die-cast aluminum poles or iron pipes.

### Disclosure of Invention

The reinforcing members, such as poles and shafts, are made of rigid iron or the like. They are inevitably heavy. The display that has heavy poles or shafts is therefore heavy as a whole.

The present invention has been made in view of the foregoing. An object of the invention is to provide a display device that is light and can yet have a display panel that is resistant to impacts.

To achieve the object, a display device according to the present invention comprises a display panel and a hollow reinforcing plate which has been made by bonding two plates together and which holds the display panel.

### Brief Description of Drawings

FIG. 1 is a diagram schematically showing a display that is an embodiment of the present invention;
FIG. 2 is a diagram schematically illustrating the display panel shown in FIG. 1;
FIG. 3 is a diagram schematically showing the display of FIG. 1 in detail;
FIG. 4 is a sectional view schematically depicting an example of the reinforcing plate shown in FIG. 1;
FIG. 5 is a sectional view schematically depicting the example of the reinforcing plate shown in FIG. 1; and
FIG. 6 is a sectional view schematically depicting another example of the reinforcing plate shown in FIG. 1.

### Best Mode for Carrying Out the Invention

Embodiments of this invention will be described in detail, with reference to the accompanying drawings. An SED will be described as an embodiment of the present invention.

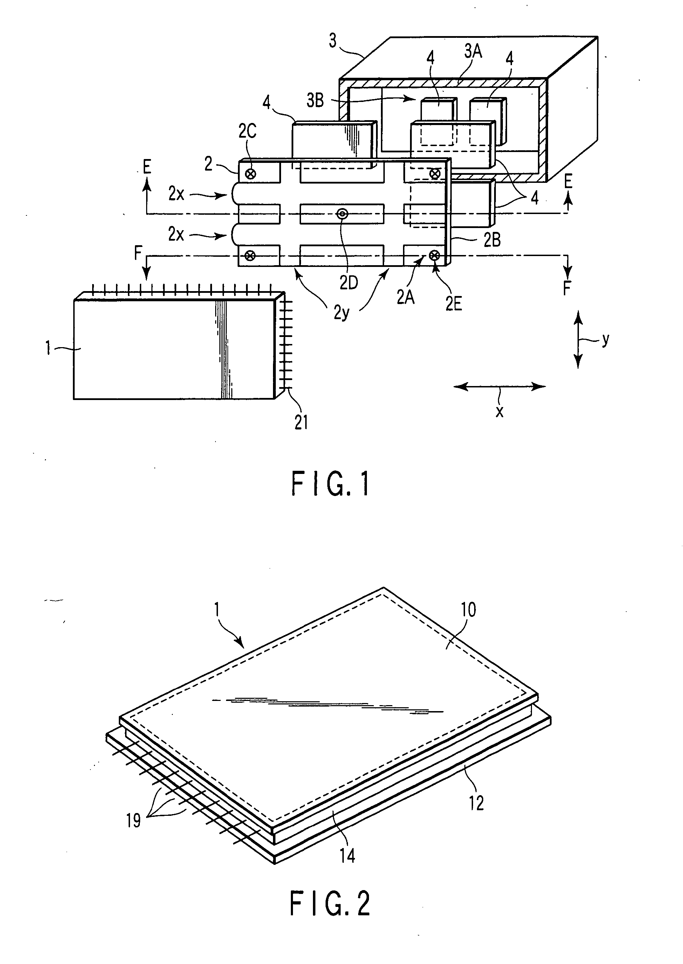

As shown in FIG. 1, the SED has a display panel 1, a reinforcing plate 2, a case 3, and circuit boards 4. The reinforcing plate 2 holds the display panel 1. The reinforcing plate 2 secures the display panel 1 to the case 3. The circuit boards 4 are arranged between the reinforcing plate 2 and the case 3 and performs various controls to make the display panel 1 display images.

The reinforcing plate 2 has a first surface 2A and a second surface 2B. The surface 2A faces the display panel 1. The surface 2B faces the case 3 and the circuit boards 4.

The first surface 2A has first beads 2x and second beads 2y. The first beads 2x extend in a first (transverse) direction x, and the second beads 2y extend in a second (longitudinal) direction y. The first beads 2x and the second beads 2y project toward the display panel 1. They are adhered to the display panel 1, by using, for example, adhesive or adhesive tape, and therefore hold the display panel 1.

More specifically, the reinforcing plate 2 is a hollow structure that is composed of two plates bonded together. It has junctions 2C and a junction 2D where the plates are welded to each other. The junctions 2C are formed at the four corners of the reinforcing plate 2. The junction 2D is formed at the center of the plate 2. Thus, the reinforcing plate 2 is composed of two plates that are bonded at four corners and at one point, at least. In the present embodiment, the junctions 2C at the four corners weld the two plates together and have a hole each. These holes are used to guide fastening members 2E that fasten the reinforcing plate 2 to the case 3. The two plates may be coupled with each other by means of adhesion using adhesive.

The case 3 covers the back of the display. The fastening members 2E fasten the reinforcing plate 2 to the peripheral edges of the case 3. First, the reinforcing plate 2 is fastened to the case 3. Then, the display panel 1 is secured to the reinforcing plate 2.

The circuit boards 4 are arranged between the reinforcing plate 2 and the case 3 and are secured to at least one surface, i.e., the second surface 2B of the reinforcing plate 2 or the inner surface of the case 3, or both. The circuit board 4 is, for example, a scanning circuit board, a common circuit board, a power-supply circuit board, a digital-signal circuit board and an analog-signal circuit board.

The display panel 1 of the SED will be described in detail.

As shown in FIG. 2, the display panel 1 comprises a front substrate 10 and a rear substrate 12. The substrates 10 and 12 are rectangular glass plates, which are opposed to each other and spaced from each other by a predetermined gap. The gap, or the distance between the substrates, is about 1.0 to 2.0 mm. The front substrate 10 and the rear substrate 12 are bonded together, with a sidewall 14 interposed between them. The sidewall 14 is a rectangular frame made of glass. The substrates 10 and 12 and the sidewall 14 constitute the flat display panel (vacuum envelope) 1, in which a vacuum is maintained.

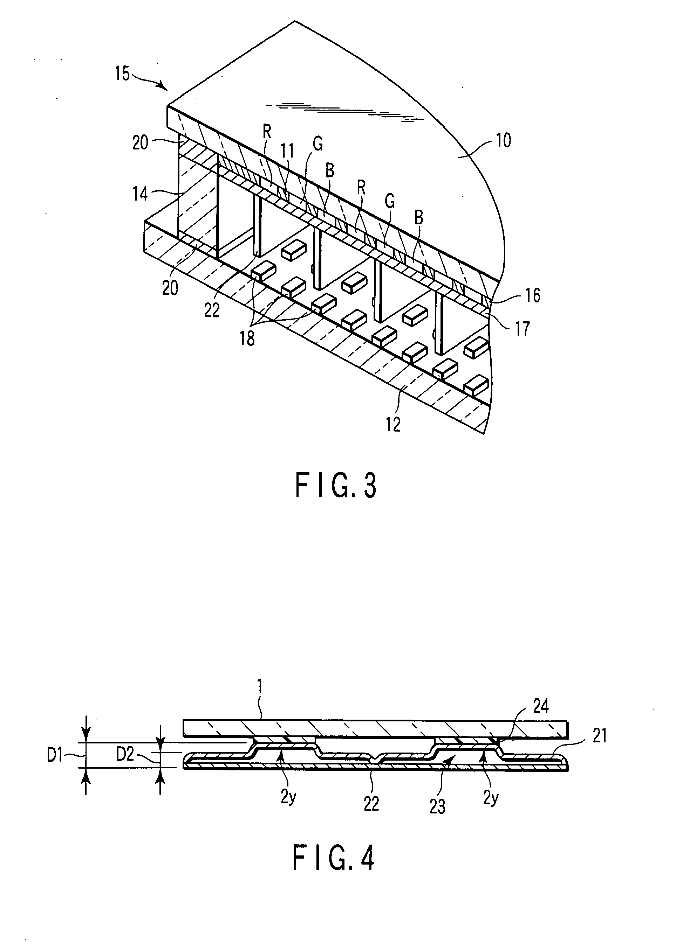

To be more specific, a phosphor screen 16 is formed on the inner surface of the front substrate 10 as shown in FIG. 3. The screen 16 functions as image display screen. The phosphor screen 16 comprises red phosphor layers R, blue phosphor layers B, green phosphor layers G, and light-shielding layers 11. The phosphor layers R, B and G are provided in the form of stripes or dots. A metal-back layer 17 made of aluminum or the like is formed on the phosphor screen 16.

On the inner surface of the rear substrate 12, a number of electron emission elements 18 of surface-conduction type are provided. The electron emission elements 18 are sources of electrons and emit electron beams, which will excite the phosphor layers R, G and B of the phosphor screen 16. The electron emission elements 18 are arranged in rows and columns, each provided for one pixel. Each electron emission element 18 comprises an electron-emitting member (not shown) and a pair of element electrodes configured to apply a voltage to the electron-emitting member. On the inner surface of the rear substrate 12, a number of wires 19 are arranged in the form of a matrix, to apply a potential to each electron emission element 18. The wires are led, at one end, from the display panel 1.

The sidewall 6 that functions as coupling member is bonded to the peripheral edges of the front substrate 10 and the peripheral edges of the rear substrate 12, with sealing material 20 such as lo-melting glass or low-melting metal, thus bonding the substrates to each other.

The display panel 1 has a plurality of spacers 22, which are rectangular plates provided between the front substrate 10 and the rear substrate 12. The spacers 22 are arranged in the form of strips, abutting on the inner surface of the front substrate 10 and the inner surface of the rear substrate 12. The spacers 22 support the front substrate 10 and the rear substrate 12 against the atmospheric pressure exerted to these substrates 10 and 12, maintaining the gap between the substrates at a predetermined value. The shape of the spacers is not limited to the one shown. The spacers may be, for example, columnar ones.

To display an image, the electron emission elements 18 are driven via the wires 19, causing selected electron emission elements to emit electron beams. At the same time, an anode voltage is applied to the phosphor screen 16 and the metal-back layer 17. The anode voltage accelerates the electron beams emitted from the electron emission elements. The electron beams are applied to the phosphor screen 16, exciting the phosphor layers R, G and B of the screen 16. The phosphor layers emit color light beams. As a result, a color image is displayed.

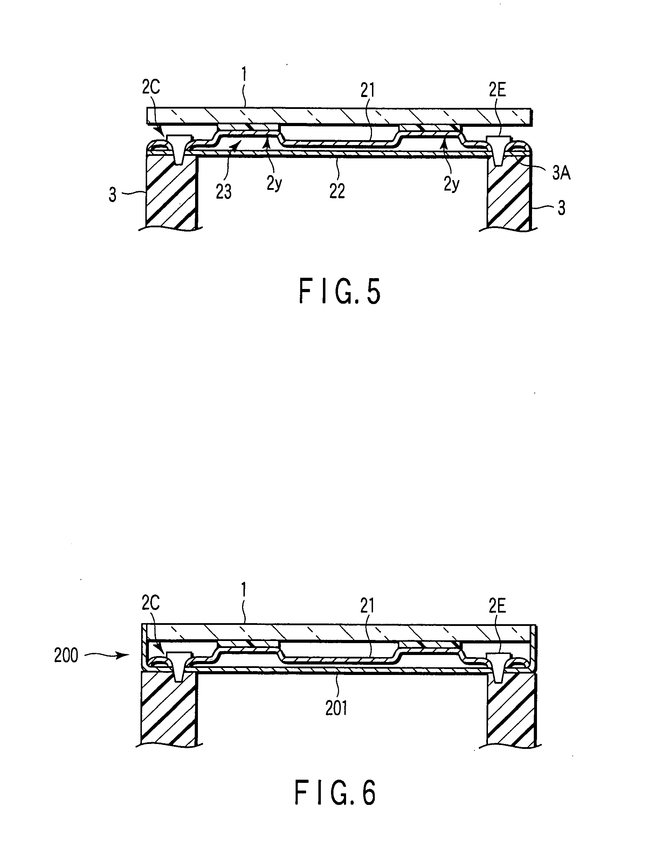

The reinforcing plate 2 will be described in greater detail, with reference to FIGS. 4 and 5. FIG. 4 is a sectional view of the structure shown in FIG. 1, taken along line E-E shown in FIG. 1. FIG. 5 is a sectional view of this structure, taken along line F-F.

As shown in FIGS. 4 and 5, the reinforcing plate 2 is a hollow structure comprising two plates 21 and 22 that are fastened to each other at peripheral edges. Spaces 23 are provided between the plates 21 and 22. The plates 21 and 22 are made of, for example, iron, aluminum, magnesium alloy, fiber-reinforced plastics, non-plastic ceramics, carbon fiber, or the like. In the present embodiment, the plates 21 is 2.5 mm thick, and the plate 22 is 3 mm thick.

On the plate 21 having the first surface 2A that faces the display panel 1, the first beads 2x and second beads 2y are formed and adhered by adhesive layers 24 to the display panel 1. The first beads 2x and the second beads 2y can be formed by means of, for example, press molding or injection molding. If they are formed by press molding, the plate 21 can be manufactured at lower cost.

As indicated above, the plates 21 and 22 are welded together, at the junctions 2C, i.e., four corners, and the junction 2D, the center. As FIG. 5 shows, the junctions 2C penetrate the plates 21 and 22, making through holes. Fastening members 2E are inserted in the through holes. The fastening members 2E extend through the reinforcing plate 2, connecting the reinforcing plate 2 to the case 3.

In this embodiment, once the plates 21 and 22 have been welded together, the reinforcing plate 2 has thickness D1 of 7 mm at the first beads 2x and the second beads 2y, and thickness D2 of 6 mm at the other parts, i.e., lower parts.

A display thus configured and assembled was placed in a cardboard box and held steady therein, using packaging material. Then, the box containing the display was dropped from a preset height to determine the impact-resistance of the display (thus performing a package-dropping impact test). The display according to this invention was found to withstand an impact of at least 50 G. A display having a reinforcing plate having no beads at all and made of one plate was placed in a cardboard box and held steady therein, using the same packaging material, and the box containing this display was subjected to the same package-dropping impact test. The display panel 1 of this display was broken, not withstanding an impact of 20 G.

The reinforcing plate 2 is thus bonded to the display panel 1, only at the first and second beads 2x and 2y. In addition, the spaces provided in the first and second beads 2x and 2y are larger than those provided at any other parts, between the plates 21 and 22. The impact applied to the display panel 1 is therefore absorbed in the spaces 23 as it is transmitted through the first beads 2x and the second beads 2y. Namely, the reinforcing plate 2 can disperse the impact applied to the display panel 1, suppressing the transmission of impact to the circuit boards 4. Hence, the display can be improved in terms of impact resistance.

Having a plurality of first beads 2x extending in X direction and a plurality of second beads 2y extending in Y direction, the reinforcing plate 2 can have its rigidity enhanced. The larger the display panel 1, the more first beads 2x and the more second beads 2y the reinforcing plate 2 may have. Then, the rigidity of the reinforcing plate 2 will increase, thus enhancing the strength of the display panel 1.

Being a hollow structure, the reinforcing plate 2 is lighter than in the case it is solid. The display as a whole can therefore be lighter than otherwise.

Moreover, the display panel 1 can be protected from damages, because the fastening members 2E are arranged in a region at a level lower than the first beads 2x and the second beads 2y, that is, in that part of the first surface 2A which is remote from the display panel 1 and the tops of the fastening members 2E therefore not contact the display panel 1. Furthermore, the display can be manufactured in few steps, because no recesses must be made in the reinforcing plate 2 for receiving the fastening members 2E in order to prevent the fastening members 2E from contacting the display panel 1.

Further, since the plates 21 and 22 are bonded together, not only at peripheral edges, but also at four corners and at another point, the plates 21 and 22 can be prevented from warping. This avoids any deformation of the reinforcing plate 2.

The present invention is not limited to the embodiment described above. The through holes for guiding the fastening members 2E may be made in parts of the plates 21 and 22, other than the junctions 2C at the four corners. Further, the projection-recess pattern on the first surface 2A of the reinforcing plate 2 may be any other than the pattern defined by two first beads 2x and two second beads 2y. For example, it may be defined by more first beads 2x and more second beads 2y.

A reinforcing plate 2 according to another embodiment will be described, with reference to FIG. 6.

As FIG. 6 shows, this reinforcing plate 200 is constituted by the above-mentioned plate 21 and a plate 201, which are bonded to each other. The plate 201 is larger, having four sides lying outside those of the plate 21. Like the reinforcing plate 2, the reinforcing plate 200 is a hollow structure. The plate 201 is welded to the plate 21 at peripheral edges and at four junctions 2C and junction 2D at the center. The plate 201 may be coupled with the plate 21 and its peripheral edges by means of adhesion using adhesive.

The peripheral edges of the plate 201, which protrude outwards from the junction with the plate 21, are bent toward the peripheral edges of the plate 21. The parts of the plate 201, thus bent, have such a size that they cover the peripheral edges of the display panel 1 as long as the plate 21 holds the display panel 1 and do not project from the display panel to the display screen.

Thus configured, the plate 201 protects the peripheral edges of the display panel 1. This further enhances the impact resistance.

In this embodiment, the plates 21 and 22 are coupled, each caulked at all peripheral edges. The display can therefore be manufactured in fewer steps than in the case the plates are bonded together at all peripheral edges by using adhesive.

### Industrial Applicability

The present invention can provide a display device that is light and can yet have a display panel that is resistant to impacts.

## Claims

1. A display device comprising:
a display panel; and
a hollow reinforcing plate which has been made by bonding two plates together and which holds the display panel.

2. The display device according to claim 1, wherein at least one of the plates of the reinforcing plate has projections and recesses.

3. The display device according to claim 2, wherein the reinforcing plate is adhered, at the projections formed on one plate, to the display panel, and screw holes are made in the recesses made in the surface of said one plate.

4. The display device according to claim 3, wherein the reinforcing plate has junctions where the two plates are bonded, at fourth corners and one point, at least.

5. The display device according to claim 1, wherein the reinforcing plate is made of iron, aluminum, magnesium alloy, fiber-reinforced plastics, non-plastic ceramics, carbon fiber, or the like.

6. The display device according to claim 1, wherein the reinforcing plate is constituted by a first plate adhered to the display panel and a second plate having peripheral edges which protrude outwards from peripheral edges of the display panel and which are bent toward the peripheral edges of the display panel.
